# EUROPÄISCHE PATENTSCHRIFT

(11) **EP 0 683 902 B1**
(45) Veröffentlichungstag und Bekanntmachung des Hinweises auf die Patenterteilung: **26.08.1998**
(21) Anmeldenummer: 94905683.2
(22) Anmeldetag: 22.01.1994
(51) Int. Cl.: G03F 7/00

(54) **VERFAHREN ZUM HERSTELLEN VON MIKROSTRUKTURELEMENTEN AUF EINEM SUBSTRAT**
PROCESS FOR PRODUCING MICRO-STRUCTURE COMPONENTS ON A SUBSTRATE
PROCEDE DE PRODUCTION D'ELEMENTS PRESENTANT UNE MICROSTRUCTURE SUR UN SUBSTRAT

(30) Priorität: 13.02.1993 DE 4304424
(43) Veröffentlichungstag der Anmeldung: 29.11.1995
(73) Patentinhaber: Forschungszentrum Karlsruhe GmbH, 76133 Karlsruhe (DE)
(72) Erfinder: MICHEL, Andreas, D-76344 Eggenstein-Leopoldshafen (DE); HARMENING, Michael, D-69493 Hirschberg (DE); BACHER, Walter, D-76297 Stutensee (DE); BLEY, Peter, D-76344 Eggenstein-Leopoldshafen (DE); RUPRECHT, Robert, D-75045 Walzbachtal (DE); BOTH, Alexander, D-76185 Karlsruhe (DE)
(74) Vertreter: Rückert, Friedrich, Dr.
(86) Internationale Anmeldenummer: EP9400169
(87) Internationale Veröffentlichungsnummer: WO9418605

(56) Entgegenhaltungen:
- WO-A-89/01632
- DE-A- 3 937 308

## Beschreibung

Die Erfindung betrifft ein Verfahren zum Herstellen von Mikrostrukturelementen auf einem Substrat gemäß dem Oberbegriff des ersten oder des dritten Patentanspruchs.

Mit dem Verfahren gemäß dem Oberbegriff des ersten Patentanspruchs werden auf dem Substrat Mikrostrukturelemente aus Kunststoff aufgebaut, die mit den integrierten Schaltkreisen über elektromechanische oder optische Kopplungen funktional zusammenwirken. Mit dem Verfahren gemäß dem Oberbegriff des dritten Patentanspruchs werden auf dem Substrat Mikrostrukturelemente aus Metall aufgebaut, die mit den integrierten Schaltkreisen auf elektrischem Weg funktional zusammenwirken.

Solche Verfahren sind aus der EP 0 371 069 B1 bekannt. Gemäß dieser Druckschrift lassen sich Mikrosensoren mit integrierter Signalverarbeitung herstellen, wobei die elektronischen Schaltkreise für die Signalverarbeitung und die mit diesen gekoppelten, metallischen Sensorstrukturen auf einem gemeinsamen Substrat räumlich unmittelbar benachbart gefertigt werden.

Hierzu werden zuerst die elektronischen Schaltkreise auf dem Substrat nach den Methoden der Halbleitertechnik gefertigt. Auf dem Substrat wird eine leitfähige Schicht aufgebracht, die so strukturiert wird, daß nach Maßgabe des Grundrisses der herzustellenden Sensorstrukturen sowie der erforderlichen Leiterbahnen und Anschlüsse für die Schaltkreise eine flächenhaft strukturierte Galvanikelektrode entsteht. Danach wird auf dem mit der Galvanikelektrode versehenen Substrat eine Schicht eines Röntgenresists aufgebracht, wobei die Dicke der Schicht einer charakteristischen Höhe der Sensorstrukturen entspricht. Auf röntgenlithographischem Weg werden in dieser Schicht Negative der Sensorstrukturen hergestellt, wonach ein Metall oder eine Metallegierung in die Negative der Sensorstrukturen galvanisch unter Verwendung der Galvanikelektrode abgeschieden wird. Schließlich wird das Substrat mit den darauf aufgebrachten Sensorstrukturen in einzelne Funktionseinheiten (Chips) aufgeteilt.

Bei diesem Verfahren kann es vorkommen, daß durch die Bestrahlung mit Röntgenstrahlen, die zur röntgenlithographischen Herstellung der Negative der Sensorstrukturen notwendig ist, die mikroelektronischen Schaltungen geschädigt werden. Die Sensorstrukturen werden neben den elektronischen Schaltkreisen aufgebaut, so daß auf dem Substrat Platz für die Sensorstrukturen freigehalten werden muß.

Aus der DE 39 37 308 C1 ist ein Verfahren zur Herstellung von metallischen Mikrostrukturkörpern bekannt, bei dem auf einer elektrisch leitfähigen Grundplatte mittels Mikroabformtechnik Negativformen der Mikrostrukturkörper aus Kunststoff erzeugt und die Hohlräume der Negativformen galvanisch unter Verwendung der elektrisch leitfähigen Grundplatte als Elektrode aufgefüllt werden. Das Verfahren ist dadurch gekennzeichnet, daß im Zuge der Erzeugung der Negativformen eine Restschicht des Kunststoffs als Boden der Hohlräume der Negativformen auf der elektrisch leitfähigen Grundplatte belassen wird und daß vor dem galvanischen Auffüllen der Hohlräume der Negativformen mit Metall die Restschicht des Kunststoffs am Boden der Hohlräume durch reaktives Ionenätzen mittels senkrecht gegen die Oberfläche der Grundplatte bescheunigter Ionen entfernt wird.

Weiterhin ist aus dieser Patentschrift bekannt, daß der Kunststoff auf der Grundplatte mit Hilfe einer als Haftvermittler dienenden Zwischenschicht aufgebracht werden kann.

Dieses Verfahren dient jedoch nicht zum Herstellen von Mikrostrukturelementen auf einem Substrat, auf dem zuvor elektronische Schaltkreise angebracht wurden, die später mit den Mikrostrukturelementen funktional zusammenwirken.

Um ein solches Substrat, z. B. einen prozessierten Wafer, zu beschichten, müssen verschiedene Bedingungen eingehalten werden.

Voraussetzung ist, daß die Mikrostrukturelemente auf dem prozessierten Wafer zuverlässig haften. Die Haftkräfte des Kunststoffs, aus dem die Mikrostrukturelemente bestehen, dürfen jedoch nicht so groß sein, daß bei der Strukturierung der Kunststoffschicht Probleme auftreten, wenn gemäß der bereits genannten DE 39 37 308 C1 ein Abformwerkzeug verwendet wird. Ein solches Abformwerkzeug muß sich von den Mikrostrukturelementen abziehen lassen, ohne daß die Mikrostrukturelemente beschädigt werden und ohne sie vom Substrat abzulösen oder deren Verbund mit dem Substrat zu schwächen. Dies ist deswegen problematisch, weil die Flächen, über die die Mikrostrukturelemente mit dem Substrat verbunden sind, prinzipiell kleiner sind als diejenigen Flächen, mit denen die ausgeformten Mikrostrukturelemente zum Werkzeug in Kontakt stehen.

Außerdem muß sichergestellt sein, daß bei der Herstellung der Mikrostrukturelemente die empfindlichen elektronischen Schaltkreise auf dem Substrat nicht beschädigt werden.

Diese Bedingungen werden bei einem Verfahren der eingangs genannten Art erfüllt, wenn die im ersten und dritten Patentanspruch gekennzeichneten Verfahrensschritte durchgeführt werden. Bevorzugte Ausgestaltungen dieser Verfahren sind in den abhängigen Patentansprüchen beschrieben.

Erfindungsgemäß wird auf den prozessierten Wafer, der nach Standard der Mikroelektronik eine Schicht aus Siliziumdioxid oder Siliziumnitrid als Deckschicht besitzt, eine erste Schicht des Kunststoffs aufgetragen. Als Kunststoff für die erste Schicht eignet sich insbesondere Polymethylmethacrylat (PMMA) und zwar in der Form von Gießharzsystemen, obwohl auch andere Kunststoffe wie z. B. Polyamid (PA), Polycarbonat (PC) oder Polyethersulfon (PES) verwendet werden können. Die erste Schicht bewirkt eine feste Verbindung sowohl zum prozessierten Wafer als auch zu der nachfolgend aufzubringenden zweiten Schicht des Kunststoffs.

Ist die Oberfläche nicht ausreichend mikrorauh, so wird der ersten Schicht des Kunststoffs ein interner Haftvermittler zugemischt. Wird als Kunststoff PMMA eingesetzt, wird vorzugsweise ein solcher Haftvermittler zugemischt, dessen Moleküle eine reaktive Methacrylat-Gruppe als Endgruppe aufweisen.

Als Haftvermittler können die Stoffe Hydroethylmethacrylat (HEMA), Hydroxylethylmetacrylphosphat (HEMA-P), Chloro-proypltrimethosilan (CMO) oder Methacryloxypropyltri-methoxysilan (MEMO) eingesetzt werden. Die Konzentration des Haftvermittlers im Kunststoff der ersten Schicht soll vorzugsweise im Bereich zwischen 0,5 und 2 Gewichtsteilen liegen.

Die Dicke der ersten Schicht soll vorzugsweise einige µm betragen; sie kann im Bereich zwischen 0,5 µm und 50 µm liegen. Die Schichtdicke soll so groß sein, daß Rauhigkeiten des Substrats überdeckt werden.

Die Festigkeit der ersten Schicht des Kunststoffs hängt von der Mikrorauhigkeit der Oberfläche des prozessierten Wafers bzw. der leitfähigen Oberfläche, von der Konzentration und Typ des Haftvermittlers im Zusammenwirken mit dem Substrat und von der Art der Auftragung ab.

Wird die erste Schicht auf dem Wafer aufpolymerisiert, beeinflussen Druck und Temperatur der Schicht während der Polymerisation die Festigkeit. Die auf den Wafer aufgegossene Schicht kann beispielsweise durch Aufpressen einer Platte während der Polymerisation unter Druck gehalten werden. Hierbei ist darauf zu achten, daß die Mindestschichtdicke nicht unterschritten wird, wenn überschüssiger Kunststoff durch die Platte verdrängt wird.

Nach der Polymerisation der ersten Schicht kann das Substrat mit dem Kunststoff der ersten Schicht auch bei kalthärtenden Systemen getempert werden. Dadurch wird die Restmonomerkonzentration auf unter 1 % vermindert und der Schicht eine hohe Festigkeit verliehen. Für PMMA sind Temper-Temperaturen im Bereich zwischen 80 °C und 120 °C geeignet. Durch das Tempern der Schicht unterhalb der Glasübergangstemperatur für die Dauer von 1 bis 72 Stunden und nachfolgendem langsamen Abkühlen werden außerdem die Eigenspannungen durch Relaxation vermindert.

Wie erwähnt, wird auf die erste Schicht eine zweite Schicht des Kunststoffs aufgetragen. Dem Kunststoff für die zweite Schicht wird jedoch zuvor ein internes Trennmittel zugemischt. Ein geeignetes Trennmittel ist z. B. Zinkstearat. Gute Ergebnisse werden mit Trennmitteln erzielt, die unter der Handelsbezeichnung PAT von der Fa. Würz, Bingen vertrieben werden.

Das Trennmittel soll dem Kunststoff vorzugsweise in einer Konzentration von mindestens 1 Gew.-% beigemischt werden. Da mit zunehmender Trennmittelkonzentration die Haftwirkung des Kunststoffs zwar abnimmt, jedoch in steigendem Maß Poren im Kunststoff gebildet werden, wird man den Trennmittelanteil im Kunststoff auf 4 % begrenzen.

Die Dicke der zweiten Schicht soll um einige 10 µm größer sein als die herzustellenden Mikrostrukturelemente, vor allem wenn der Flächendeckungsgrad der Mikrostrukturelemente über 50 % liegt gegenüber der Fläche des prozessierten Wafers, die vom Werkzeug mit der Umformkraft beaufschlagt wird. Die zweite Schicht kann in der gleichen Weise wie die erste Schicht aufgetragen werden.

Als nächster Schritt wird die zweite Schicht mit einem Abformwerkzeug strukturiert. Das Werkzeug trägt vorzugsweise Mikrostrukturen, die zu den Mikrostrukturelementen komplementär sind, wenn die Mikrostrukturelemente aus Kunststoff bestehen sollen. Sollen Mikrostrukturelemente aus Metall aufgebaut werden, trägt das Werkzeug vorzugsweise Mikrostrukturen, die den Mikrostrukturelementen entsprechen. Die Höhe der Mikrostrukturen entspricht vorzugsweise der Höhe der herzustellenden Mikrostrukturelemente. Das Werkzeug wird so abgeformt, daß ausschließlich die zweite Schicht mit den Mikrostrukturelementen versehen wird. Wegen des Anteils an internem Trennmittel in der zweiten Schicht läßt sich das Werkzeug leicht abziehen, ohne daß der Wafer oder die Mikrostrukturkörper aus Kunststoff beschädigt werden.

Sollen die Wafer nicht Mikrostrukturelemente aus Kunststoff, sondern Mikrostrukturen aus Metall tragen, so wird die Siliziumoxid- oder Siliziumnitridoberfläche der prozessierten Wafer so strukturiert, daß die Leiterbahnen der Mikroelektronik an den Stellen freigelegt werden, auf denen später die Mikrostrukturelemente aus Metall mit der Mikroelektronik funktional verbunden sind. In nachfolgenden Verfahrensschritten werden die erzeugten Mikrostrukturen aus Kunststoff galvanisch mit einem Metall, z. B. Nickel, abgeformt und danach der Kunststoff entfernt, so daß auf dem Wafer Mikrostrukturelemente bestehen bleiben, die denen des Werkzeugs entsprechen.

Hierfür muß ein Substrat eingesetzt werden, dessen galvanisch zu beschichtende Oberfläche zumindest teilweise elektrisch leitfähig ist. Vorzugsweise wird ein prozessierter Wafer als Substrat eingesetzt, der zuvor beispielsweise gemäß der eingangs zitierten EP 0 371 069 B1 durch Aufstäuben oder durch Aufdampfen mit einer 2 bis 10 µm dicken Schicht des Metalls versehen worden ist. Diese Metallschicht kann z. B. aus Titan, Wolfram, oder Aluminium bestehen. Das aufgesputterte Titan wird naßchemisch oxidiert und die erste Schicht des Kunststoffs mit z.B. 2 % MEMO als interner Haftvermittler aufgebracht. Wird Wolframoxid oder anodisch oxidiertes Aluminiumoxid (ca. 10 % H3PO4, 1A/dm2 5 min., 24° C) als Metallschicht verwendet, so kann man bei PMMA als Kunststoff in der ersten Schicht auf einen Haftvermittler verzichten.

Eine erste Schicht des Kunststoff ohne internen Haftvermittler kann von Vorteil sein, wenn das Werkzeug nicht nur die zweite Schicht strukturiert, sondern mit der Werkzeugstirnfläche in die ersten Schicht hineinprägt, um eine geringe Restschichtdicke des Kunststoffs nach dem Umformen zu erzielen. Damit kann nach dem Umformen des Kunststoffs die nachfolgende, zeitaufwendige Bearbeitung der ersten Schicht des Kunststoffs zur Freilegung der Metallschicht reduziert werden. In manchen Fällen kann es vorteilhaft sein, wenn diese Metallschicht mit lithographischen und ätztechnischen Methoden strukturiert wurde, so daß die elektrisch leitfähige Schicht z. B. nur an den für die galvanische Abscheidung oder als Leitungsbahnen benötigten Stellen vorhanden ist.

Die elektrisch leitfähige Oberfläche des Substrats wird in diesem Fall vor der galvanischen Abscheidung von Metall freigelegt, d. h., an den zu galvanisierenden Stellen werden die erste Schicht und gegebenenfalls störende Reste der zweiten Schicht entfernt. Die Entfernung kann gemäß der eingangs zitierten DE 39 37 308 C1 durch senkrecht zur Oberfläche gerichtete Sauerstoffionen erfolgen. Ist die erste Schicht des Kunststoffs entfernt, kann sich die galvanische Abscheidung von Metall anschließen.

Alternativ kann eine leitfähige, für die galvanische Abscheidung von Metall verwendbare Schicht erzeugt werden, indem die Stirnflächen des Werkzeugs gemäß der DE 35 37 483 C1 mit einer ablösbaren, elektrisch leitfähigen Schicht überzogen werden, die bei der Strukturierung der zweiten Schicht auf das Substrat übertragen wird.

Wie bei dem eingangs genannten, gattungsgemäßen Verfahren kann anschließend das Substrat durch mechanisches Teilen in einzelne Chips zerlegt werden. Dabei wird der durch die leitfähige Schicht zwischen den metallischen Mikrostrukturelementen hergestellte Kurzschluß aufgehoben. Falls das Substrat nicht in Chips aufgeteilt ist, kann die elektrisch leitende Schicht an den Stellen, die nicht galvanisch mit Metall überdeckt wurden, weggeätzt werden, um den elektrischen Kurzschluß zwischen den metallischen Mikrostrukturelementen aufzuheben.

Ein wesentlicher Vorteil des erfindungsgemäßen Verfahrens besteht darin, daß die Mikrostrukturelemente direkt auf den elektronischen Schaltkreisen aufgebaut werden können, so daß eine höhere Integrations- und Packungsdichte erreicht wird.

Das Verfahren nutzt zur Erzeugung der Mikrostrukturelemente auf einem prozessierten Wafer keine Röntgenstrahlung, die C-MOS-Schaltungen in ihrer Funktion beeinträchtigen kann.

## Patentansprüche

1. Verfahren zum Herstellen von Mikrostrukturelementen auf einem Substrat, das elektronische Schaltkreise trägt, welche mit den Mikrostrukturelementen funktional zusammenwirken, wobei
a) auf dem Substrat eine Schicht aus einem Kunststoff aufgebracht wird, deren Dicke mindestens der Höhe der herzustellenden Mikrostrukturelemente entspricht und
b) die Schicht strukturiert wird,
gekennzeichnet durch die folgenden Verfahrensschritte:
c) auf das Substrat wird eine erste Schicht des Kunststoffs aufgetragen, die mit dem Substrat eine feste Verbindung eingeht,
d) auf die erste Schicht wird eine zweite Schicht eines Kunststoffs aufgetragen, wobei dem Kunststoff zuvor ein internes Trennmittel zugemischt wurde,
e) die zweite Schicht wird mit Hilfe eines mit Mikrostrukturen versehenen Werkzeugs strukturiert, wonach
f) das Werkzeug abgezogen wird.

2. Verfahren nach Anspruch 1, dadurch gekennzeichnet, daß das Werkzeug zu den Mikrostrukturelementen komplementäre Mikrostrukturen trägt.

3. Verfahren zum Herstellen von Mikrostrukturelementen auf einem Substrat, das elektronische Schaltkreise trägt, welche mit den Mikrostrukturelementen funktional zusammenwirken, wobei
a) auf dem Substrat eine Schicht aus einem Kunststoff aufgebracht wird, deren Dicke mindestens der Höhe der herzustellenden Mikrostrukturelemente entspricht und
b) die Schicht strukturiert wird,
c) die strukturierte Schicht mit einem Metall ausgefüllt und danach
d) die Schicht aus dem Kunststoff selektiv gegenüber dem Metall entfernt wird,
gekennzeichnet durch die folgenden Verfahrensschritte:
e) auf das Substrat wird eine erste Schicht des Kunststoffs aufgetragen, die mit dem Substrat eine feste Verbindung eingeht,
f) auf die erste Schicht wird eine zweite Schicht eines Kunststoffs aufgetragen, wobei dem Kunststoff zuvor ein internes Trennmittel zugemischt wurde,
g) die zweite Schicht wird mit Hilfe eines mit Mikrostrukturen versehenen Werkzeugs strukturiert, wonach
h) das Werkzeug abgezogen wird.

4. Verfahren nach Anspruch 1 oder 3, dadurch gekennzeichnet, daß dem Kunststoff für die erste Schicht zuvor ein interner Haftvermittler beigemischt wurde.

5. Verfahren nach Anspruch 3, dadurch gekennzeichnet, daß das Werkzeug den Mikrostrukturelementen entsprechende Mikrostrukturen trägt.

6. Verfahren nach Anspruch 3, dadurch gekennzeichnet, daß ein Substrat eingesetzt wird, das auf seiner später den Schichten des Kunststoffs zugewandten Seite zumindest teilweise mit einer elektrisch leitfähigen Oberfläche überzogen ist.

7. Verfahren nach Anspruch 6, dadurch gekennzeichnet, daß nach dem Strukturieren der zweiten Schicht die erste Schicht in den strukturierten Bereichen mittels reaktivem Ionenätzen oder durch Abstäuben vollständig entfernt wird, so daß die elektrisch leitfähige Oberfläche des Substrats freigelegt ist.

## Claims

1. Method of producing microstructure elements on a substrate carrying electronic switching circuits, which functionally co-operate with the microstructure elements,
a) a layer of a plastics material being applied to the substrate, the thickness of said layer corresponding at least to the height of the microstructure elements to be produced, and
b) the layer being structured,
characterised by the following method steps:
c) a first layer of the plastics material is applied to the substrate and establishes a firm connection with the substrate,
d) a second layer of a plastics material is applied to the first layer, an internal parting agent having previously been mixed with the plastics material, and
e) the second layer is structured by means of a tool provided with microstructures, whereupon f) the tool is withdrawn.

2. Method according to claim 1, characterised in that the tool carries microstructures which are complementary to the microstructure elements.

3. Method of producing microstructure elements on a substrate carrying electronic switching circuits, which functionally co-operate with the microstructure elements,
a) a layer of a plastics material being applied to the substrate, the thickness of said layer corresponding at least to the height of the microstructure elements to be produced, and
b) the layer being structured,
c) the structured layer being filled with a metal, and then
d) the layer of the plastics material being selectively removed from the metal,
characterised by the following method steps:
e) a first layer of the plastics material is applied to the substrate and establishes a firm connection with the substrate,
f) a second layer of a plastics material is applied to the first layer, an internal parting agent having previously been mixed with the plastics material, and
g) the second layer is structured by means of a tool provided with microstructures, whereupon
h) the tool is withdrawn.

4. Method according to claim 1 or 3, characterised in that an internal bonding agent was previously added to the plastics material for the first layer.

5. Method according to claim 3, characterised in that the tool carries microstructures corresponding to the mictostructure elements.

6. Method according to claim 3, characterised in that a substrate is used which is coated at least partially with an electrically conductive surface on its side subsequently facing the layers of the plastics material.

7. Method according to claim 6, characterised in that, after the structuring of the second layer, the first layer in the structured regions is completely removed by means of reactive ionic etching or by dust-extraction, so that the electrically conductive surface of the substrate is exposed.

## Revendications

1. Procédé de production d'éléments de microstructure sur un substrat qui porte des circuits de commutation électroniques qui coopèrent fonctionnellement avec les éléments de microstructure,
dans lequel
a) sur le substrat, on applique une couche d'une matière plastique, dont l'épaisseur correspond au moins à la hauteur des éléments de microstructure à produire et
b) la couche est structurée,
caractérisé par
les étapes suivantes de procédé :
c) sur le substrat, on applique une première couche de la matière plastique, qui établit avec le substrat une liaison solide,
d) sur la première couche, on applique une deuxième couche d'une matière plastique, dans laquelle précédemment on a mélangé un agent adhésif interne,
e) la deuxième couche est structurée à l'aide d'un outil muni de microstructures, à la suite de quoi
f) l'outil est retiré.

2. Procédé selon la revendication 1,
caractérisé en ce que
l'outil porte des microstructures complémentaires aux éléments de microstructure.

3. Procédé de production d'éléments de microstructure sur un substrat, qui porte des circuits de commutation électroniques, qui coopèrent fonctionnellement avec les éléments de microstructure,
dans lequel
a) sur le substrat on applique une couche d'une matière plastique, dont l'épaisseur correspond au moins à la hauteur des éléments de microstructure à produire et
b) la couche est structurée,
c) la couche structurée est remplie avec un métal et après cela,
d) la couche en matière plastique est enlevée sélectivement par rapport au métal,
caractérisé par les étapes suivantes de procédé :
e) sur le substrat, on applique une première couche de matière plastique, qui établit avec le substrat une liaison solide,
f) sur la première couche, on applique une deuxième couche d'une matière plastique, dans laquelle précédemment on a mélangé un agent séparateur interne,
g) la deuxième couche est structurée à l'aide d'un outil muni de microstructures, après quoi
h) l'outil est retiré.

4. Procédé selon la revendication 1 ou 3,
caractérisé en ce qu'
on mélange à la matière plastique de la première couche précédemment un agent adhésif interne.

5. Procédé selon la revendication 3,
caractérisé en ce que
l'outil porte des éléments de microstructure correspondant aux microstructures.

6. Procédé selon la revendication 3,
caractérisé en ce qu'
on utilise un substrat qui est garni au moins partiellement d'une surface conductrice de l'électricité sur sa face tournée ultérieurement vers les couches de la matière plastique.

7. Procédé selon la revendication 6,
caractérisé en ce qu'
après la structuration de la deuxième couche la première couche est éliminée complètement dans les zones structurées au moyen de corrosion réactive ionique ou par élimination en poussière, de sorte que la surface du substrat conductrice électrique est dégagée.
